# EUROPEAN PATENT APPLICATION

(11) **EP 4 368 747 A1**
(43) Date of publication of application: **15.05.2024**
(21) Application number: 22930431.6
(22) Date of filing: 21.04.2022
(51) Int. Cl.: C23C 16/513, C23C 16/455

(54) **DROOPING COVER PLATE, AND PECVD DEVICE HAVING DROOPING COVER PLATE**

(30) Priority: 07.03.2022 CN 202210223385
(71) Applicant: Suzhou Maxwell Technologies Co., Ltd., Suzhou, Jiangsu 215200 (CN); Suzhou Maizheng Technology Co. Ltd, Suzhou, Jiangsu 215200 (CN)
(72) Inventor: LIU, Yanan, Suzhou, Jiangsu 215200 (CN); ZHANG, Bin, Suzhou, Jiangsu 215200 (CN); CHEN, Chen, Suzhou, Jiangsu 215200 (CN); WANG, Dengzhi, Suzhou, Jiangsu 215200 (CN); LIU, Huan, Suzhou, Jiangsu 215200 (CN)
(74) Representative: Sackin, Robert
(86) International application number: PCT/CN2022/088109
(87) International publication number: WO 2023/168802

(57) **Abstract**

The present invention belongs to the technical field of PECVD devices. Disclosed are a drooping cover plate and a PECVD device having the drooping cover plate. In the drooping cover plate of the present invention, a first insulating frame is arranged on a bottom plate frame, and a second insulating frame is arranged on the first insulating frame; the bottom plate frame is formed of several bottom plates connected to each other, a lower side face of each bottom plate is provided with an extension portion that is perpendicular to the lower side face of the bottom plate; the first insulating frame is formed of several first insulating plates joined together, and the second insulating frame is formed of several second insulating plates joined together; and several strip-shaped holes communicating an inner side and an outer side of the bottom plate frame are formed between upper side surfaces of the bottom plates and lower side surfaces of the first insulating plates and between upper side surfaces of the first insulating plates and lower side surfaces of the second insulating plates, and the height of each strip-shaped hole in a thickness direction of the bottom plate frame is 1-20 mm. The drooping cover plate in the present embodiment can greatly improve the processing efficiency and yield of a vacuum deposition process.

## Description

### TECHNICAL FIELD

The present invention relates to the technical field of PECVD apparatuses, in particular to a pendent shield frame and a PECVD apparatus having the same.

### BACKGROUND

In the vacuum deposition process of solar cells using a PECVD apparatus, a tray carrying the wafers is dynamically transported into a process chamber, and then processed by static deposition. The tray generally stays under a cathode of the PECVD apparatus, and the gap between the tray and the cathode serves as a channel for gas flow. When SiH4 plasma glow discharge is used, glow will be unstable between a shield frame and the cathode, a large number of particle clusters gather to form a yellow solid powder, that is, yellow powder.

In the vacuum deposition process, when a vacuum pump draws away the gas and yellow powder through the channel between the tray and the cathode, the yellow powder will inevitably fall on the chamber, tray and shield frame. At the same time, since the tray generally needs to be recycled, excessive yellow powder will accumulate on the tray, resulting in a shortened production cycle. In addition, since there is also yellow powder on the shield frame, it accumulates and falls onto a product, reducing the product yield.

In the related art, by providing a plurality of exhaust holes to quickly discharge the gas after the reaction, the generation of yellow powder can only be avoided to a small extent, and the generated yellow powder cannot be removed in time. When the number of times of cyclic use of the tray reaches a certain value, the yellow powder will still accumulate, thereby reducing processing efficiency and yield rate.

### SUMMARY

### 1. Technical problems solved by the present invention

The object of the present invention is to address the shortcomings in the related art that when PECVD apparatus performs vacuum deposition processing, it tends to accumulate yellow powder and reduce the processing efficiency and yield rate. A pendent shield frame and a PECVD apparatus having the pendent shield frame are provided to avoid accumulation of yellow powder in a process chamber to improve processing efficiency and yield rate.

### 2. Technical solution

In order to achieve the above object, the technical solution provided by the present invention is:

A pendent shield frame includes a bottom plate frame, a first insulating frame, and a second insulating frame. The first insulating frame is provided on the bottom plate frame, and the second insulating frame is provided on the first insulating frame. The bottom plate frame is formed by connecting a plurality of bottom plates, and a lower side of the bottom plate is provided with an extending portion perpendicular to the lower side of the bottom plate. The first insulating frame is formed by splicing a plurality of first insulating plates, and the second insulating frame is formed by splicing a plurality of second insulating plates. An upper side of the bottom plate is in contact with a lower side of the first insulating plate, and an upper side of the first insulating plate is in contact with a lower side of the second insulating plate, thereby forming a plurality of strip-shaped holes communicating the inner and outer sides of the bottom plate frame. A height of the strip-shaped hole in a thickness direction of the bottom plate frame is 1mm to 20mm.

Further, an inner side of the second insulating frame is coplanar with an inner side of the first insulating frame, an outer side of the second insulating frame is coplanar with an outer side of the first insulating frame, the inner side of the first insulating frame protrudes from the inner side of the bottom plate frame, and the outer side of the bottom plate frame protrude from the outer side of the first insulating frame.

Further, a position of the first insulating plate corresponds to a position of the second insulating plate, and the strip-shaped hole is formed between the first insulating plate and the second insulating plate at the corresponding positions.

Further, the upper side of the first insulating plate is provided with a plurality of upper convex portions, the lower side of the second insulating plate is provided with a plurality of lower convex portions at positions corresponding to the upper convex portions, and in the same first insulating plate, the strip-shaped hole is formed between adjacent two upper convex portions.

Further, the upper side of the first insulating plate is provided with a first upper convex portion, a second upper convex portion, and a third upper convex portion, the second upper convex portion is located between the first upper convex portion and the third upper convex portion, the lower side of the second insulating plate is provided with the first lower convex portion, the second lower convex portion, and the third lower convex portion corresponding to the first upper convex portion, the second upper convex portion and the third upper convex portion, respectively, a first strip-shaped hole is formed between the first upper convex portion and the second upper convex portion, and a second strip-shaped hole is formed between the second upper convex portion and the third upper convex portion.

Further, a left side of the first upper convex portion protrudes from a left side of the first lower convex portion, and the right side of the third lower convex portion protrude from a right side of the third upper convex portion.

Further, the bottom plate is provided with a first protrusion at a position corresponding to a second upper convex portion, the bottom plate is provided with a second protrusion portion at a position corresponding to the first upper protrusion portion and the third upper protrusion portion, and a third strip-shaped hole is formed between the first protrusion and the second protrusion.

Further, the first insulating plate is provided with a first fixing hole at a position of the second upper convex portion, the second insulating plate provided with a second fixing hole at a position of the second lower convex portion, the bottom plate is provided with a connecting hole on the first protrusion, a fastener is used to extend through the first fixing hole and the second fixing hole and then is connected to the connecting hole, so as to fix the first insulating plate and the second insulating plate on the bottom plate.

Further, at least one fixing plate is connected to the bottom plate frame, one of the left and right sides of the fixing plate is provided with a pressing portion, and the other one of left and right sides of the fixing plate is provided with a support portion, the pressing portion is configured to tightly press a portion of the left side of the first upper convex portion that protrudes from the left side of the first lower convex portion, the support portion is tightly pressed by a portion of the right side of the third lower convex portion that protrudes from the right side of the third upper convex portion.

A pendent shield frame of the present invention, includes a bottom plate frame and an insulating frame provided on the bottom plate frame. The bottom plate frame is formed by connecting a plurality of bottom plates. A lower side of the bottom plate is provided with an extending portion perpendicular to the lower side of the bottom plate. The insulating frame is formed by splicing a plurality of insulating plates. An upper side of the bottom plate is in contact with a lower side of the insulating plate. The insulating plate is integrally formed and processed. A plurality of strip-shaped holes communicating inner and outer sides of the bottom plate frame are formed in an interior of the insulating plate. A height of the strip-shaped hole in a thickness direction of the bottom plate frame is 1mm to 20mm.

A PECVD apparatus of the present invention, includes the pendent shield frame cover plate according to any one of claims 1 to 9. The pendent shield frame is provided in a process chamber of the PECVD apparatus, and a bottom plate of the pendent shield frame is fixed to a cathode of the PECVD apparatus.

### 3. Beneficial effects

Compared with the prior art, the technical solution provided by the present invention has the following beneficial effects:
(1) According to the pendent shield frame of the present invention, the first insulating frame is provided on the bottom plate frame, and the second insulating frame is provided on the first insulating frame. The bottom plate frame is formed by connecting a plurality of bottom plates, and the lower side of the bottom plate is provided with an extending portion perpendicular to the lower side of the bottom plate. The first insulating frame is formed by splicing a plurality of first insulating plates, and the second insulating frame is formed by splicing a plurality of second insulating plates. A plurality of strip-shaped holes communicating the inner and outer sides of the bottom plate frame are formed between the upper side of the bottom plate and the lower side of the first insulating plate and between the upper side of the first insulating plate and the lower side of the second insulating plate. The height of the strip-shaped hole in the thickness direction of the bottom plate frame is mm to mm. Therefore, on the one hand, the height of the strip-shaped hole in the thickness direction of the bottom plate frame is very small, and the strip-shaped hole is similar to a slit. When the process gas flows through the strip-shaped hole, glow discharge is less likely to generate, so that yellow powder is less likely to be generated. On the other hand, when the process gas flows through the strip-shaped hole, the cross-section of the strip-shaped hole is much smaller than that of the process chamber, resulting in an increase in the flow rate of the process gas. Even if a trace amount of yellow powder is formed in the strip-shaped hole, the yellow powder can be blown away by the airflow, so that the yellow powder can be prevented from falling onto a workpiece in the process chamber, greatly improving the processing efficiency and yield rate of the vacuum deposition process.
(2) In the present invention, the upper side of the first insulating plate may be provided with a first upper convex portion, a second upper convex portion and a third upper convex portion. The lower side of the second insulating plate may be provided with a first lower convex portion, a second lower convex portion, and a third lower convex portion corresponding to the first upper convex portion, the second upper convex portion and the third upper convex portion, respectively. The left side of the first upper convex portion protrudes from the left side of the first lower convex portion, and the right side of the third lower convex portion protrudes from the right side of the third upper convex portion. Therefore, when assembling the pendent shield frame, the portion of the right side of the third lower convex portion protruding from the right side of the third upper convex portion can be used to press the portion of the left side of the first upper convex portion on the adjacent first insulating plate that protrudes from of the left side of the first lower convex portion, thereby improving the overall strength of the pendent shield frame and improving assembly efficiency.
(3) In the present invention, at least one fixing plate is connected to the bottom plate frame. One of the left and right sides of the fixing plate is provided with a pressing portion, and the other one of the left and right sides of the fixing plate is provided with a support portion. The pressing portion is configured to press the portion of the left side of the first upper convex portion that protrudes from the left side of the first lower convex portion. The support portion is tightly pressed by the portion of the right side of the third lower convex portion that protrudes from the right side of the third upper convex portion. The pendent shield frame of the present invention can be assembled by using a plurality of first insulating plates and second insulating plates of standard sizes to form pendent shield frames of different sizes, and the fixing plate of variable size can be used to fine-tune the size of the pendent shield frame.

### BRIEF DESCRIPTION OF THE DRAWINGS

FIG. 1 is a schematic structural view of a pendent shield frame of the present invention.
FIG. 2 is a schematic view of a cooperation relationship between a fastener and a first insulating plate and a second insulating plate of the present invention.
FIG. 3 is a schematic view of a cooperation relationship between a fixing plate and the first insulating plate and the second insulating plate of the present invention.
FIG. 4 is a schematic view of the overall shape of the pendent shield frame of the present invention.

### DETAILED DESCRIPTION OF THE EMBODIMENTS

The present invention will be described in detail with reference to the accompanying drawings and embodiments in order to further understand the present invention.

The structures, proportions, sizes, etc. shown in the drawings are only used to cooperate with the contents disclosed in the specification for the understanding and reading of those who are familiar with the technology, and are not used to limit the conditions for the implementation of the present invention, so they have no technical significance. Any modification of the structure, change of the scale relationship or adjustment of the size, without affecting the efficacy and the purpose of the present invention, should still fall within the scope of the technical content disclosed in the present invention. Meanwhile, the terms such as "up", "down", "left", "right" and "middle", etc. quoted in the specification are only for the sake of clarity of description, and are not used to limit the scope of implementation. The change or adjustment of the relative relationship should also be regarded as the scope of implementation of the present invention without substantial change in technical content.

In the related arts, a shield frame is provided surrounding a cathode nozzle of a PECVD apparatus. The shield frame is coplanar with the cathode nozzle, and the shield frame is generally made of metal or ceramic. At the same time, since the shield frame and the cathode nozzle are insulated from each other, disordered discharge at the edge of the cathode nozzle can be suppressed during vacuum deposition processing.

However, even if the shield frame is provided surrounding the cathode nozzle, the tray carrying a product to be processed stays under a cathode of the PECVD apparatus, and when vacuum deposition is performed, a gap between the tray and the cathode forms a channel for the flow of process gases. When using SiH4 plasma for glow discharge, glow will be unstable between the shield frame and the cathode, resulting in yellow powder, i.e., high-order silane powder. Therefore, during the vacuum deposition process, when a vacuum pump draws the process gas and yellow powder away through the channel between the tray and the cathode, the yellow powder easily falls on a process chamber, the tray and shield frame, and falls on the product, thereby reducing the yield rate of the product. After processing, yellow powder accumulated on the process chamber, tray and shield frame will shorten the production cycle, thus reducing the processing efficiency of PECVD apparatus.

In order to solve the above problem, the present embodiment provides a pendent shield frame, which includes a bottom plate 100, a first insulating frame, and a second insulating frame. Strip-shaped holes are formed between the bottom plate 100 and the first insulating frame and between the first insulating frame and the second insulating frame. The strip-shaped hole structure is configured to suppress the accumulation of yellow powder.

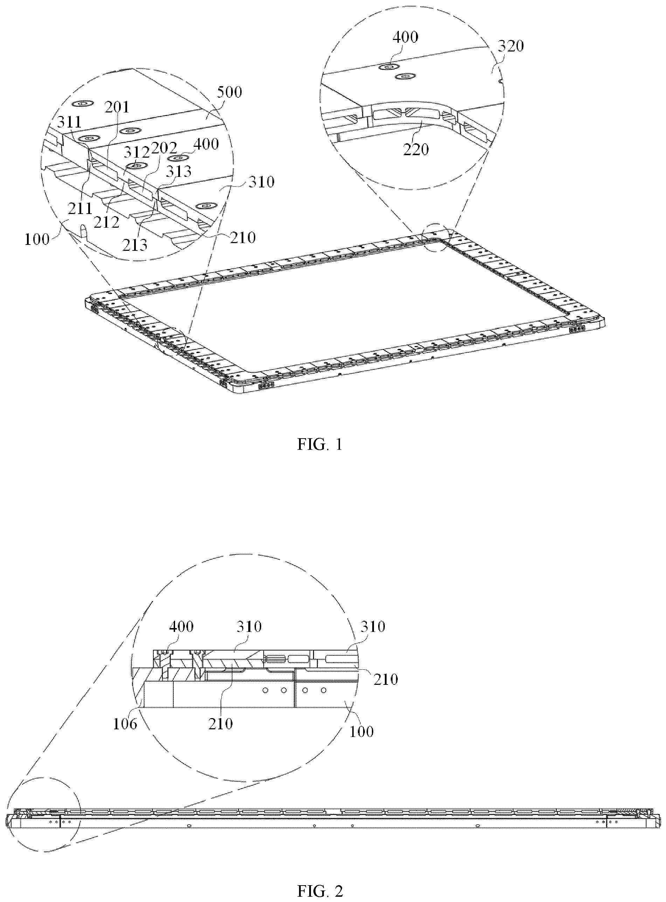

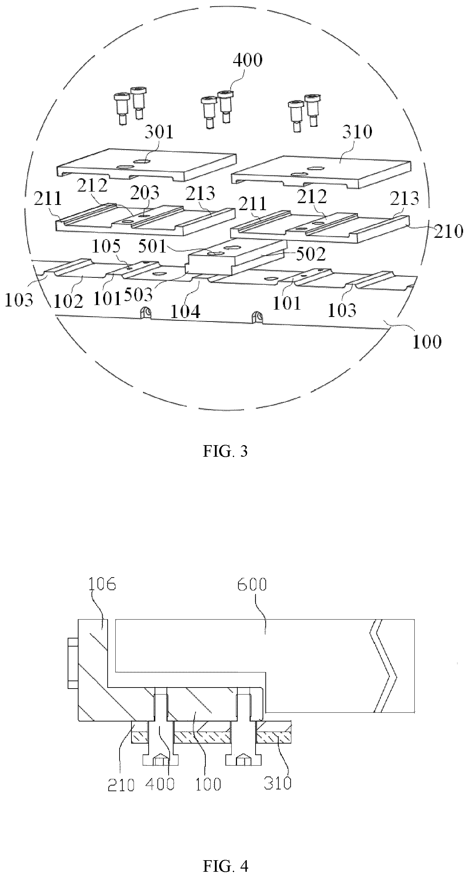

Specifically, referring to FIG. 1, the first insulating frame may be provided on the bottom plate 100 frame, and the second insulating frame may be provided on the first insulating frame. Referring to FIG. 4, the bottom plate 100 frame may be formed by connecting a plurality of bottom plates 100. A lower side of the bottom plate 100 may be provided with an extending portion 106, and the extending portion 106 may be perpendicular to the lower side of the bottom plate 100, so that the overall cross-section of the pendent shield frame is L-shaped. The first insulating frame may be formed by splicing a plurality of first insulating plates 210. The second insulating frame may be formed by splicing a plurality of second insulating plates 310. A first transition plate 220 may be provided at the corner of the first insulating frame, and a second transition plate 320 may be provided at the corner of the second insulating frame. The first transition plate 220 and the second transition plate 320 may be arc-shaped structures. Two ends of the first transition plate 220 are connected to two first insulating plates 210, respectively. Two ends of the second transition plate 320 are connected to two second insulating plates 310, respectively. The pendent shield frame surrounds the periphery of the cathode 600. Other components are also provided between the bottom 100 and the cathode 600 according to the apparatus requirements.

In addition, a plurality of strip-shaped holes communicating inner and outer sides of the bottom plate 100 frame may be formed between an upper side of the bottom plate 100 and a lower side of the first insulating plate 210, and between an upper side of the first insulating plate 210 and a lower side of the second insulating plate 310. A height of the strip-shaped hole in a thickness direction of the bottom plate 100 frame may be 1mm to 20mm.

Therefore, according to the pendent shield frame provided in the present embodiment, the strip-shaped holes between the bottom plate 100 and the first insulating frame, and between the first insulating frame and the second insulating frame are actually formed into a narrow-slit structure. Therefore, when the process gas flows through the strip-shaped hole, since the height of the strip-shaped hole in the thickness direction of the bottom plate 100 frame is 1mm to 20mm, the conditions for glow discharge is not met, and thus the process gas is not likely to react and form yellow powder. On the other hand, when the process gas flows through the strip-shaped hole, the cross-section of the strip-shaped hole is much smaller than that of the process chamber, resulting in an increase in the flow rate of the process gas. Even if a trace amount of yellow powder is formed in the strip-shaped hole, the yellow powder can be blown away by the airflow, so that the yellow powder can be prevented from falling onto a workpiece in the process chamber, greatly improving the processing efficiency and yield rate of the vacuum deposition process.

As a further optimization, an inner side of the second insulating frame can be coplanar with an inner side of the first insulating frame, and an outer side of the second insulating frame can be coplanar with tan outer side of the first insulating frame. The inner side of the first insulating frame can protrude from the inner side of the bottom plate 100 frame, and the outer side of the bottom plate 100 frame can protrude from the outer side of the first insulating frame. The portions of the first insulating frame and the second insulating frame that protrude from the bottom plate 100 frame can shield the edge of the workpiece to be processed and avoid the occurrence of glow discharge. At the same time, the extending portion 106 may be provided on the outer edge of the bottom plate 100 frame.

In the present embodiment, a position of the first insulating plate 210 may correspond to a position of the second insulating plate 310, and the strip-shaped hole may be formed between the first insulating plate 210 and the second insulating plate 310 at the corresponding positions, that is, the first insulating plate 210 and the second insulating plate 310 may be provided in pairs. In addition, the structures of the first insulating plate 210 and the second insulating plate 310 may be the same.

Specifically, the upper side of the first insulating plate 210 may be provided with a plurality of upper convex portions, and the lower side of the second insulating plate 310 may be provided with a plurality of lower convex portions at positions corresponding to the upper convex portions. In the same first insulating plate 210, the strip-shaped hole can be formed between adjacent two upper convex portions.

More specifically, the upper side of the first insulating plate 210 may be provided with a first upper convex portion 211, a second upper convex portion 212 and a third upper convex portion 213. The second upper convex portion 212 is located between the first upper convex portion 211 and the third upper convex portion 213. The lower side of the second insulating plate 310 may be provided with a first lower convex portion 311, a second lower convex portion 312, and a third lower convex portion 313 corresponding to the first upper convex portion 211, the second upper convex portion 212 and the third upper convex portion 213, respectively. A first strip-shaped hole 201 may be formed between the first upper convex portion 211 and the second upper convex portion 212, and a second strip-shaped hole 202 may be formed between the second upper convex portion 212 and the third upper convex portion 213.

As a further optimization, a left side of the first upper convex portion 211 can protrude from a left side of the first lower convex portion 311, and a right side of the third lower convex portion 313 can protrude from a right side of the third upper convex portion 213. Therefore, when assembling the pendent shield frame, a portion of the right side of the third lower convex portion 313 protruding from the right side of the third upper convex portion 213 can be used to tightly press the portion of the left side of the first upper convex portion 211 on the adjacent first insulating plate 210 that protrudes from of the left side of the first lower convex portion 311, thereby improving the overall strength of the pendent shield frame and improving assembly efficiency.

In the present embodiment, the bottom plate 100 may be provided with a first protrusion 101 at a position corresponding to the second upper convex portion 212, and the bottom plate 100 may be provided with a second protrusion portion 103 at a position corresponding to the first upper protrusion portion 211 and the third upper protrusion portion 213. A third strip-shaped hole may be formed between the first protrusion 101 and the second protrusion 103. Specifically, a groove 102 can be provided between the first protrusion portion 101 and the second protrusion 103. After the pendent shield frame is assembled, the lower side of the first insulating plate 210 can cover the groove 102, thereby forming the third strip-shaped hole.

As further optimization, referring to FIG. 3, the first insulating plate 210 is provided with a first fixing hole 203 at a position of the second upper convex portion 212, the second insulating plate 310 may be provided with a second fixing hole 301 at a position of the second lower convex portion 312, and the bottom plate 100 may be provided with a connecting hole 105 on the first protrusion 101. A fastener 400 can be used to extend through the first fixing hole 203 and the second fixing hole 301 and then be connected to the connecting hole 105, so as to fix the first insulating plate 210 and the second insulating plate 310 on the bottom plate 100.

In addition, at least one fixing plate 500 is connected to the bottom plate 100 frame. One of left and right sides of the fixing plate 500 can be provided with a pressing portion 502, and the other one of the left and right sides of the fixing plate 500 can be provided with a support portion 503. Therefore, when assembling the pendent shield frame, the pressing portion 502 of the fixing plate 500 can be used to tightly press the portion of the left side of the first upper convex portion 211 on the adjacent first insulating plate 210 that protrudes from the left side of the first lower convex portion 311. The support portion 503 can be tightly pressed by the portion of the right side of the third lower convex portion 313 that protrudes from the right side of the third upper convex portion 213, thereby improving the overall strength of the pendent shield frame and improving assembly efficiency.

Referring to FIG. 3, in order to facilitate the connection between the bottom plate 100 and the fixing plate 500, the bottom plate 100 is provided with a third protrusion portion 104 at a position corresponding to the fixing plate 500, and the fixing plate 500 is provided with a third fixing hole 501 at a position corresponding to the third protrusion portion 104. During assembly, the fastener 400 can be used to extend through the third fixing hole 501 and connected to the third protrusion portion 104 to fix the fixing plate 500 on the bottom plate 100. In addition, the third protrusion 104 and the adjacent first protrusion 101 may also be formed with the third strip-shaped hole.

It should be noted that when the bottom plate 100 is provided with the fixing plate 500, the third protrusion portion 104 is provided at a position of the bottom plate 100 corresponding to the fixing plate 500, and the third protrusion portion 104 replaces the second protrusion 103 that should be provided at that position.

In addition, the pendent shield frame of other embodiments may include a bottom plate frame and an insulating frame, and the insulating frame is provided on the bottom plate frame. The bottom plate frame is formed by connecting a plurality of bottom plates. The lower side of the bottom plate is provided with an extending portion perpendicular to the lower side of the bottom plate. The insulating frame is formed by splicing a plurality of insulating plates. The upper side of the bottom plate is in contact with the lower side of the insulating plate, and the insulating frame is integrally formed and processed, and a plurality of strip-shaped holes communicating inner side and the outer side of the bottom plate frame are formed in the insulating plate. The height of the strip-shaped hole in the thickness direction of the bottom plate frame is 1mm to 20mm.

The present embodiment also provides a PECVD apparatus. In the PECVD apparatus, the pendent shield frame is provided in a process chamber of the PECVD apparatus, and the bottom plate 100 of the pendent shield frame is fixed on a cathode of the PECVD apparatus. The pendent shield frame may be the pendent shield frame in the present embodiment.

The present invention and its embodiments are schematically described above, which is not intended to be limiting. What is shown in the drawings is only one of the embodiments of the present invention, and the actual structure is not limited thereto. Therefore, if person skilled in the art is inspired by the present invention and without departing from the spirit of the present invention, can devise structures and embodiments similar to the technical solution without creative efforts, the structures and the embodiments shall all fall within the protection scope of the invention.

## Claims

1. A pendent shield frame, comprising a bottom plate frame, a first insulating frame, and a second insulating frame, wherein the first insulating frame is provided on the bottom plate frame, the second insulating frame is provided on the first insulating frame, the bottom plate frame is formed by connecting a plurality of bottom plates, a lower side of the bottom plate is provided with an extending portion perpendicular to the lower side of the bottom plate, the first insulating frame is formed by splicing a plurality of first insulating plates, the second insulating frame is formed by splicing a plurality of second insulating plates, an upper side of the bottom plate is in contact with a lower side of the first insulating plate, and an upper side of the first insulating plate is in contact with a lower side of the second insulating plate, thereby forming a plurality of strip-shaped holes communicating inner and outer sides of the bottom plate frame, and a height of the strip-shaped hole in a thickness direction of the bottom plate frame is 1mm to 20mm.

2. The pendent shield frame according to claim 1, wherein an inner side of the second insulating frame is coplanar with an inner side of the first insulating frame, an outer side of the second insulating frame is coplanar with an outer side of the first insulating frame, the inner side of the first insulating frame protrudes from the inner side of the bottom plate frame, and the outer side of the bottom plate frame protrudes from the outer side of the first insulating frame.

3. The pendent shield frame according to claim 1, wherein a position of the first insulating plate corresponds to a position of the second insulating plate, and the strip-shaped hole is formed between the first insulating plate and the second insulating plate at the corresponding positions.

4. The pendent shield frame according to claim 3, wherein the upper side of the first insulating plate is provided with a plurality of upper convex portions, the lower side of the second insulating plate is provided with a plurality of lower convex portions at positions corresponding to the upper convex portions, and in the same first insulating plate, the strip-shaped hole is formed between adjacent two upper convex portions.

5. The pendent shield frame according to claim 4, wherein the upper side of the first insulating plate is provided with a first upper convex portion, a second upper convex portion, and a third upper convex portion, the second upper convex portion is located between the first upper convex portion and the third upper convex portion, the lower side of the second insulating plate is provided with the first lower convex portion, the second lower convex portion, and the third lower convex portion corresponding to the first upper convex portion, the second upper convex portion, and the third upper convex portion, respectively, a first strip-shaped hole is formed between the first upper convex portion and the second upper convex portion, and a second strip-shaped hole is formed between the second upper convex portion and the third upper convex portion.

6. The pendent shield frame according to claim 5, wherein a left side of the first upper convex portion protrudes from a left side of the first lower convex portion, and a right side of the third lower convex portion protrude from a right side of the third upper convex portion.

7. The pendent shield frame according to claim 6, wherein the bottom plate is provided with a first protrusion at a position corresponding to the second upper convex portion, the bottom plate is provided with a second protrusion portion at a position corresponding to the first upper protrusion portion and the third upper protrusion portion, and a third strip-shaped hole is formed between the first protrusion and the second protrusion.

8. The pendent shield frame according to claim 7, wherein the first insulating plate is provided with a first fixing hole at a position of the second upper convex portion, the second insulating plate provided with a second fixing hole at a position of the second lower convex portion, the bottom plate is provided with a connecting hole on the first protrusion, a fastener is used to extend through the first fixing hole and the second fixing hole and then is connected to the connecting hole, so as to fix the first insulating plate and the second insulating plate on the bottom plate.

9. The pendent shield frame according to claim 7, wherein at least one fixing plate is connected to the bottom plate frame, one of left and right sides of the fixing plate is provided with a pressing portion, and the other one of the left and right sides of the fixing plate is provided with a support portion, the pressing portion is configured to tightly press a portion of the left side of the first upper convex portion that protrudes from the left side of the first lower convex portion, and the support portion is tightly pressed by a portion of the right side of the third lower convex portion that protrudes from the right side of the third upper convex portion.

10. A pendent shield frame, comprising a bottom plate frame and an insulating frame provided on the bottom plate frame, wherein the bottom plate frame is formed by connecting a plurality of bottom plates, a lower side of the bottom plate is provided with an extending portion perpendicular to the lower side of the bottom plate, the insulating frame is formed by splicing a plurality of insulating plates, an upper side of the bottom plate is in contact with a lower side of the insulating plate, the insulating plate is integrally formed and processed, a plurality of strip-shaped holes communicating inner and outer sides of the bottom plate frame are formed in an interior of the insulating plate, and a height of the strip-shaped hole in a thickness direction of the bottom plate frame is 1mm to 20mm.

11. A PECVD apparatus, comprising the pendent shield frame according to any one of claims 1 to 10, wherein the pendent shield frame is provided in a process chamber of the PECVD apparatus, and a bottom plate of the pendent shield frame is fixed to a cathode of the PECVD apparatus.
